# EUROPÄISCHE PATENTANMELDUNG

(11) **EP 3 829 273 A1**
(43) Veröffentlichungstag der Anmeldung: **02.06.2021**
(21) Anmeldenummer: 20214312.9
(22) Anmeldetag: 12.12.2014
(51) Int. Cl.: H05K 1/18, H05K 3/46, H05K 1/02

(54) **LEITERPLATTE MIT EINGEBETTETEN KOMPONENTE**

(30) Priorität: 12.12.2013 AT 508212013
(62) Teilanmeldung aus: 14825088.9
(71) Anmelder: AT & S Austria Technologie & Systemtechnik Aktiengesellschaft, 8700 Leoben-Hinterberg (AT)
(72) Erfinder: Schwarz, Timo, 8770 Sankt Michael in Obersteiermark (AT); Zluc, Andreas, 8700 Leoben (AT); Langer, Gregor, 9061 Wölfnitz (AT); Stahr, Johannes, 8605 St. Lorenzen (AT)
(74) Vertreter: Dilg, Haeusler, Schindelmann Patentanwaltsgesellschaft mbH

(57) **Zusammenfassung**

Eine Leiterplatte (200) bzw. ein Leiterplatten-Zwischenprodukt (200) weisen einen Verbund (100) von Schichten mit zumindest einer isolierenden Schicht (1) aus einem Prepreg-Material, wobei der Verbund (100) von Schichten eine erste Seite und eine zweite Seite hat, und eine in dem Verbund (100) von Schichten eingebettete Komponente (6) auf, die Kontakte (7) hat und durch ein Harz des Prepreg-Materials festgelegt ist. Die Kontakte (7) der Komponente (6) sind in derselben Ebene der Leiterplatte (200) bzw. des Leiterplatten-Zwischenprodukts (200), die durch die erste Seite definiert ist, unmittelbar durch erste Leiterzüge (10) oder Mikrovias (11) ankontaktiert.

## Beschreibung

Die vorliegende Erfindung betrifft ein Verfahren zum Einbetten einer Komponente in eine Leiterplatte bzw. ein Leiterplatten-Zwischenprodukt, wobei die Leiterplatte bzw. das Leiterplatten- Zwischenprodukt zumindest eine isolierende Schicht aus einem Prepreg-Material aufweist und die Komponente durch das Harz des Prepreg-Materials festgelegt wird sowie eine Leiterplatte bzw. ein Leiterplatten-Zwischenprodukt.

Leiterplatten dienen der Festlegung und elektrischen Verbindung von elektronischen Komponenten und deren Anbindung als Modul in elektronischen Geräten. In der Regel bestehen Leiterplatten aus einer Mehrzahl von sich abwechselnden Schichten aus isolierendem Material und leitendem Material, wobei die Schichten aus elektrisch leitendem Material, beispielsweise Kupfer, zu Leiterzügen strukturiert sind, die mit den Kontaktpads der elektronischen Komponenten in Verbindung stehen und diese entsprechend entflechten. Neben der Festlegung und Verbindung der elektronischen Komponenten miteinander können Leiterplatten aufgrund ihrer relativ hohen mechanischen Stabilität zusätzlich eine statische Funktion in einem elektronischen Gerät übernehmen.

Im Sinne der ständig voranschreitenden Miniaturisierung elektronischer Geräte, wie beispielsweise Mobiltelefone, Tabletcomputer und Ähnliches, werden die immer kleiner werdenden elektronischen Komponenten nicht nur auf der Oberfläche von Leiterplatten montiert und verlötet, sondern zunehmend in das Innere, den Querschnitt der Leiterplatten integriert. Ein herkömmliches Verfahren zum Einbetten von elektronischen Komponenten in Leiterplatten sieht hierbei die Herstellung von Freistellungen bzw. Löchern in der Größe und Form der einzubettenden Komponente in der Leiterplatte vor, sodass in einem darauffolgenden Schritt die Komponenten in die jeweiligen Löcher eingesetzt und dort verklebt werden können. Nachteilig beim Verkleben der Komponenten in der Leiterplatte ist jedoch, dass der Klebstoff zwangsläufig ein anderes Material als das Material der isolierenden Schicht in der Leiterplatte ist. Während die isolierenden Schichten in der Leiterplatte aus Prepreg-Materialien, wie beispielsweise FR4, also aus Harzsystemen bestehen, sind die Klebstoffe zum Einsetzen der Komponenten zumeist Lösungsmittel-basiert. Beim Verkleben der Komponenten ergeben sich somit zwangsläufig Inhomogenitäten, wobei sich aufgrund der relativ starken Erhitzung der Komponenten in der Leiterplatte im Betrieb aufgrund unterschiedlicher Wärmeausdehnungskoeffizienten der verwendeten Materialien mit der Zeit Risse bilden, was sich negativ auf die Langlebigkeit der Leiterplatte und somit der entsprechenden elektronischen Geräte auswirkt.

In der WO 2012/100274 A1 wurde daher ein Verfahren angegeben, bei welchem die Festlegung der Komponenten in der Leiterplatte nicht mit Klebstoff erfolgt, sondern mit dem Harz der Isolierschichten der Leiterplatte bewerkstelligt wird. Bei der Herstellung von Leiterplatten werden die Isolierschichten, die aus einem Prepreg-Material bestehen, durch Laminieren und Verpressen bei erhöhter Temperatur mit den leitenden Schichten verbunden. Vor dem Laminieren und Verpressen bei erhöhter Temperatur befindet sich das Harz der Prepreg-Materialien in einem nicht-ausgehärteten Zustand, welcher als B-Stage bezeichnet wird. B-Stage-Prepreg wird auf Rollen gekühlt gelagert, um ein frühzeitiges Aushärten des Harzes zu verhindern. Das Verfahren gemäß WO 2012/100274 A1 sieht nun vor, dass in einem Verbund, der aushärtbares Prepreg-Material, d.h. Prepreg-Material im B-Stage enthält, Freistellungen für die Komponenten hergestellt werden, die Komponenten in die Freistellungen bestückt und die Freistellungen bzw. Öffnungen mit den Komponenten mit weiteren Prepreg-Lagen im B-Stage und gegebenenfalls weiteren Kontaktschichten bzw. elektrisch leitenden Schichten überdeckt werden. Hierauf erfolgt das Verpressen dieses Verbunds zur fertigen Leiterplatte, bei der das Prepreg-Material ausgehärtet vorliegt, welcher ausgehärtete Zustand in der Fachwelt als C-Stage bezeichnet wird.

Nachteilig bei diesem Verfahren ist der Umstand, dass zwangsläufig ein Überdecken der Freistellungen mit den Komponenten mit weiteren Lagen erforderlich ist, sodass die Leiterplatten, die nach dem Verfahren gemäß WO 2012/100274 A1 hergestellt wurden, relativ dick waren, was dem Gedanken der Miniaturisierung zuwiderläuft.

Der Erfindung liegt daher die Aufgabe zugrunde, ein Verfahren der eingangs genannten Art dahingehend zu verbessern, dass die Freistellungen und Komponenten überdeckende Prepreg-Schichten vermieden werden können, sodass möglichst dünne Leiterplatten realisierbar sind.

Zur Lösung dieses Problems ist ein Verfahren der eingangs genannten Art erfindungsgemäß gekennzeichnet durch die folgenden Schritte:
a) Bereitstellen eines Verbundes der Schichten der Leiterplatte bzw. des Leiterplatten-Zwischenprodukts, wobei dieser Verbund zumindest ein aushärtbares Prepreg-Material enthält,
b) Herstellen einer Freistellung in dem Verbund zur Aufnahme der einzubettenden Komponente,
c) Abdecken zumindest des Bereichs der Freistellung mit einer ersten temporären Trägerschicht auf einer ersten Seite des Verbundes,
d) Positionieren der einzubettenden Komponente in der Freistellung mittels der ersten temporären Trägerschicht,
e) Abdecken zumindest des Bereichs der Freistellung auf der zweiten Seite des Verbundes mit einer zweiten temporären Trägerschicht,
f) Verpressen des Verbundes mit der Komponente unter Aushärtung des aushärtbaren Prepreg-Materials,
g) Entfernen der temporären Trägerschichten.

Es wird somit beim erfindungsgemäßen Verfahren ein Verbund aller Schichten der Leiterplatte bzw. des Leiterplatten-Zwischenprodukts bereitgestellt, wobei dieser Verbund Prepreg-Material im B-Stage, d.h. noch aushärtbares Prepreg-Material im Gegensatz zu bereits ausgehärtetem Prepreg-Material enthält. Nach dem Herstellen der Freistellung für die Komponente wird zumindest der Bereich der Freistellung gemäß Schritt c) mit einer ersten temporären Trägerschicht abgedeckt, sodass die einzubettende Komponente auf die erste ersten temporäre Trägerschicht bestückt werden kann. Nun erfolgt das Abdecken des Bereichs der Freistellung mit der darin positionierten Komponente auf der zweiten Seite des Verbundes mit einer zweiten temporären Trägerschicht. Hier kann eine wie auch immer geartete Trennfolie verwendet werden, die lediglich nach dem Aushärten des Prepreg-Materials zum C-Stage abnehmbar sein muss. Das Aushärten des Prepreg-Materials erfolgt in Schritt f) und erfolgt nach Methoden, die im Stand der Technik bestens bekannt sind. In aller Regel wird der Verbund der Schichten der Leiterplatte bzw. des Leiterplatten-Zwischenprodukts mit der bestückten Komponente und den beiden temporären Trägerschichten mit mechanischen Druck beaufschlagt und gleichzeitig erhitzt, sodass eine Quervernetzung des Harzes des Prepreg-Materials der isolierenden Schicht bzw. der isolierenden Schichten erfolgt. Beim Verpressen gemäß Schritt f) fließt das Harz des Prepreg-Materials um die Komponente herum, erfährt an den temporären Trägerschichten eine räumliche Begrenzung und härtet somit auch im Bereich der Komponenten aus, sodass sich eine kontinuierliche Harzphase durch die Prepreg-Schichten, die die isolierenden Schichten der Leiterplatte bzw. des Leiterplatten-Zwischenprodukts bilden, ergibt. Auf diese Weise treten im Betrieb der Leiterplatte, wenn sich die Komponenten erhitzen, nur geringe Spannungen auf, die ohne das Vorhandensein einer Grenzschicht, wie sie beim Verkleben zwischen Klebstoff und Harz auftritt, direkt in die umgebenden Bereiche abgeführt werden können. Da der Bereich der eingebetteten Komponente nicht von zusätzlichen Prepreg-Lagen überdeckt werden musste, um ein Verpressen zu ermöglichen, wird nach dem Entfernen der temporären Trägerschichten gemäß Schritt g) ein überaus dünnes Produkt erhalten, das den heutigen Anforderungen der Miniaturisierung in hervorragender Weise entspricht.

Das erfindungsgemäße Verfahren ist in Bezug auf eine Komponente, die eingebettet wird, definiert. Es ist jedoch für den Fachmann klar, dass in der industriellen Produktion auch eine Vielzahl von Komponenten in ein und demselben Verbund eingebettet werden können, wobei jedoch die Erfindung so zu verstehen ist, dass jeweils nur eine Komponente in jeweils eine Freistellung eingesetzt wird. In der vorliegenden Beschreibung kann daher von der Komponente in der Einzahl oder von einer Mehrzahl von Komponenten die Rede sein, was jedoch nichts am Sinn und am Wesen der vorliegenden Erfindung ändert.

Die Erfindung kann von unterschiedlichen Arten eines Verbundes der Schichten der Leiterplatte bzw. des Leiterplatten-Zwischenprodukts ausgehen. Gemäß einer bevorzugten Variante des erfindungsgemäßen Verfahrens ist es vorgesehen, dass der Verbund der Schichten der Leiterplatte bzw. des Leiterplatten-Zwischenprodukts aus einer Mehrzahl von Lagen aus einem Prepreg-Material besteht. Bei Verwendung eines solchen Verbunds in Schritt a) des erfindungsgemäßen Verfahrens resultiert eine besonders homogene Leiterplatte bzw. ein besonders homogenes Leiterplatten-Zwischenprodukt, da sich zwischen den Lagen aus einem Prepreg-Material keine leitenden Schichten befinden und das Harz des Prepreg-Materials daher vor dem Aushärten ungehindert fließen und folglich die einzubettende Komponente bzw. die einzubettenden Komponenten umfließen kann. Nach dem Verpressen und nach dem Entfernen der temporären Trägerschichten muss bei dieser bevorzugten Ausführungsform der vorliegenden Erfindung in der Regel die Verdrahtung bzw. die Entflechtung der eingebetteten Komponente bzw. Komponenten in einem darauffolgenden Bearbeitungsschritt erfolgen, in dem an den Außenseiten Leiterzüge nach bekannten Verfahren ausgebildet werden.

Um die Ausbildung von Leiterzügen zu erleichtern, ist die Erfindung gemäß einer bevorzugten Ausführungsform dahingehend weitergebildet, dass der Verbund der Schichten der Leiterplatte bzw. des Leiterplatten-Zwischenprodukts aus einer Mehrzahl von Lagen aus Prepreg- Material und beidseitig außenliegenden Kupferschichten besteht. In diesem Fall stehen nach dem Verpressen und nach dem Entfernen der temporären Trägerschichten beidseitig Kupferschichten an der Außenseite der Leiterplatte bzw. des Leiterplatten-Zwischenprodukts zur Verfügung, aus denen sich beispielsweise durch photolithographische Verfahren geeignete Leiterzüge ausbilden lassen.

Wenn die Leiterplatte bzw. das Leiterplatten-Zwischenprodukt, das mit dem erfindungsgemäßen Verfahren hergestellt werden soll, besondere Anforderungen hinsichtlich der mechanischen Stabilität erfüllen sollen, kann gemäß einer bevorzugten Ausführungsform der vorliegenden Erfindung der Verbund der Schichten der Leiterplatte bzw. des Leiterplatten-Zwischenprodukts aus einer Mehrzahl von Lagen aus Prepreg-Material und einem zentral gelegenen Core bestehen. Unter einem Core wird in der Fachwelt eine Schicht eines ausgehärteten Prepreg-Materials, beispielsweise FR4, mit beidseitig auflaminierten Kupferlagen verstanden. Solche Cores können als Standardbauelement industriell bezogen werden und bieten beim erfindungsgemäßen Verfahren eine gewisse Stabilität bereits vor dem Verpressen des aushärtbaren Prepreg-Materials im Verbund der Schichten der Leiterplatte bzw. des Leiterplatten-Zwischenprodukts, was in einer besseren Handhabbarkeit bei der Verarbeitung und zu einer erhöhten Festigkeit des fertigen Produkts führt. Gegebenenfalls kann das zentral gelegene Core zur Ausbildung von Leiterzügen entsprechend strukturiert sein.

Gemäß einer weiters bevorzugten Ausführungsform der vorliegenden Erfindung besteht der Verbund aus einer Mehrzahl von Lagen aus Prepreg-Material und einem zentral gelegenen Core sowie beidseitig außenliegenden Kupferschichten, was einer Kombination der beiden vorangehenden Varianten entspricht, wodurch die bereits beschriebenen Vorteile kombiniert erzielt werden.

Darüber hinaus ist es gemäß einer bevorzugten Ausführungsform der vorliegenden Erfindung denkbar, dass der Verbund der Schichten der Leiterplatte bzw. des Leiterplatten-Zwischenprodukts aus einer innenliegenden Schicht aus einem Prepreg-Material und beidseitig außenliegenden Cores besteht.

Das erfindungsgemäße Verfahren ermöglicht die Herstellung von Leiterplatten bzw. Leiterplatten- Zwischenprodukten mit eingebetteten Komponenten von besonders geringer Dicke. Gemäß einer bevorzugten Ausführungsform der vorliegenden Erfindung ist das erfindungsgemäße Verfahren daher dahingehend weitergebildet, dass der Verbund der Schichten der Leiterplatte bzw. des Leiterplatten-Zwischenprodukts im Wesentlichen die Dicke der einzubettenden Komponenten aufweist. Eine zu geringe Dicke würde dazu führen, dass die Komponenten über den Querschnitt der Leiterplatte ragen und folglich nicht vollständig vom Harz des Prepreg-Materials umschlossen werden könnten. Eine Dicke des Verbundes der Schichten der Leiterplatte bzw. des Leiterplatten-Zwischenprodukts, die wesentlich über die Dicke der Komponenten hinausgeht, ist jedoch ebenfalls nicht notwendig, um eine ausreichende Einbettung in das Harz des Prepreg-Materials zu gewährleisten.

Wie bereits weiter oben erwähnt, kann das erfindungsgemäße Verfahren auf eine Mehrzahl von Komponenten angewendet werden, sodass eine Mehrzahl von Komponenten in die Leiterplatte eingebettet wird. Wesentlich hierbei ist jedoch, dass das Verfahren, wie es im Hauptanspruch definiert ist, für jede einzelne Komponente ausgeführt wird, sodass jeweils eine Freistellung für jeweils eine einzubettende Komponente hergestellt wird.

Gemäß einer bevorzugten Ausführungsform der vorliegenden Erfindung ist es vorgesehen, dass Komponenten unterschiedlicher Dicke in die jeweiligen Freistellungen bestückt werden und die zweite temporäre Trägerschicht mit einer nicht haftenden Oberfläche zum Verbund der Schichten der Leiterplatte bzw. des Leiterplatten-Zwischenprodukts ausgerichtet wird. In diesem Fall wird die Dicke des Verbundes der Schichten der Leiterplatte bzw. des Leiterplatten-Zwischenprodukts nach der dicksten Komponente bzw. nach den dicksten Komponenten gewählt, sodass dünnere Komponenten den Querschnitt des Verbundes nicht vollständig durchsetzen. Aus diesem Grund muss die zweite temporäre Trägerschicht mit einer nicht haftenden Oberfläche zum Verbund der Schichten der Leiterplatte bzw. des Leiterplatten-Zwischenprodukts ausgerichtet werden, um zu verhindern, dass die Komponente beim Verpressen von einer Kleberschicht auf der zweiten temporären Trägerschicht von ersten temporären Trägerschicht abgehoben wird.

Bevorzugt ist die erste Seite des Verbundes eine Kontaktseite der Leiterplatte bzw. des Leiterplatten- Zwischenprodukts und die einzubettende Komponente wird face-up zu dieser Kontaktseite in der Freistellung befestigt.

Gemäß einer bevorzugten Weiterbildung der vorliegenden Erfindung ist sowohl die erste Seite als auch die zweite Seite des Verbundes eine Kontaktseite der Leiterplatte. In diesem Fall können beide Seiten der Leiterplatte Leiterzüge aufweisen, wodurch eine hochintegrierte und daher platzsparende Leiterplatte erhalten wird.

Von besonderem Vorteil ist dies, wenn eine Komponente mit Kontakten auf zwei gegenüberliegenden Seiten der Komponente eingebettet wird, wie dies Gegenstand einer bevorzugten Ausführungsform der vorliegenden Erfindung ist. Diese Konfiguration gestattet einen vertikalen Stromfluss, d.h. einen Stromfluss durch den Querschnitt der Leiterplatte, wobei die elektronische Komponente als Strombrücke dient.

Bevorzugt ist die Komponente aus der Gruppe bestehend aus einem integrierten Schaltkreis, einer LED, einem Kühlkörper, einer Batterie und einer Leiterplatte, insbesondere einer mehrlagigen Leiterplatte ausgewählt. Insbesondere kann die genannte Komponente jedes aktive oder passive elektronische Bauteil sein, In diesem Zusammenhang kann die elektronische Komponente auch eine voll oder teilweise bestückte Leiterplatte (Modul) oder eine MEMS oder MOEMS-Struktur sein. Die Komponente kann jedoch auch eine nicht-elektronische Komponente, beispielsweise ein Kühlelement sein, welches insbesondere aus einem metallischen Material besteht. Es ist für den Fachmann offensichtlich, dass mit dem erfindungsgemäßen Verfahren jede Art von elektronischer Komponente eingebettet werden kann, sodass diese Aufzählung nicht als erschöpfend angesehen werden sollte.

Gemäß einer besonders bevorzugten Ausführungsform der vorliegenden Erfindung ist die Komponente ein IMS-Bauteil. Die Abkürzung IMS steht für "insulated metal substrate" und bezeichnet ein Bauteil, bei dem eine dünne Isolatorschicht, beispielsweise auf Epoxyharz-Basis, zwischen einer dicken, metallischen Basisschicht, beispielsweise aus Aluminium oder Kupfer, und einer relativ dünnen leitenden Schicht, beispielsweise aus Aluminium oder Kupfer, angeordnet ist. IMS-Bauteile dienen zur Ankontaktierung und gleichzeitigen Kühlung von Leistungskomponenten, da einerseits die leitende Schicht zu Kontaktstellen und Leiterzügen strukturiert werden kann und andererseits durch die Isolatorschicht gegen die Basisschicht elektrisch isoliert ist, wobei die Isolatorschicht einen guten Wärmedurchgang zur Basisschicht gewährleistet, wo die von der Leistungskomponente anfallende Wärme dissipiert werden kann.

Bevorzugt ist die erste temporäre Trägerschicht in Form eines Klebebandes ausgebildet. Durch die Haftwirkung des Klebebandes erfolgt eine Positionierung bzw. temporäre Befestigung der Komponente, wobei allerdings die zweite temporäre Trägerschicht nicht zwingend ein Klebeband sein muss.

Die Erfindung wird nachfolgend anhand eines in der Zeichnung schematisch dargestellten Ausführungsbeispiels näher erläutert. In dieser zeigen die
Fig. 1a) bis 1e) Varianten eines Verbundes der Schichten der Leiterplatte bzw. des Leiterplatten- Zwischenprodukts gemäß Schritt a) des erfindungsgemäßen Verfahrens,
Fig.2 eine Darstellung von Schritt b) des erfindungsgemäßen Verfahrens,
Fig.3 eine Darstellung von Schritt c) des erfindungsgemäßen Verfahrens,
Fig.4 eine Darstellung von Schritt d) des erfindungsgemäßen Verfahrens,
Fig.5 eine Darstellung von Schritt e) des erfindungsgemäßen Verfahrens,
Fig.6 eine Darstellung von Schritt f) des erfindungsgemäßen Verfahrens,
Fig.7 eine Darstellung von Schritt g) des erfindungsgemäßen Verfahrens,
Fig.8 eine mögliche Art der Weiterverarbeitung der mit dem erfindungsgemäßen Verfahren hergestellten Leiterplatte bzw. des Leiterplatten-Zwischenprodukts mit einer Ankontaktierung der eingebetteten Komponenten in der Ebene der Kontaktpads der eingebetteten Komponenten,
Fig.9 eine mögliche Art der Weiterverarbeitung der mit dem erfindungsgemäßen Verfahren hergestellten Leiterplatte bzw. des Leiterplatten-Zwischenprodukts mit einer Ankontaktierung in einer über der Ebene der Kontaktpads der eingebetteten Komponenten liegenden Kontaktschicht,
Fig. 10 eine Darstellung entsprechend Schritt e) des erfindungsgemäßen Verfahrens, wobei Komponenten unterschiedlicher Dicke in den Freistellungen positioniert wurden,
Fig.11 die Weiterverarbeitung des Zwischenprodukts gemäß Fig. 10 im Sinne der Schritte f) und g) des erfindungsgemäßen Verfahrens,
Fig. 12 eine mögliche Art der Ankontaktierung der gemäß der Fig. 10 und 11 eingebetteten Komponenten,
Fig. 13 eine Darstellung einer Variante bei der unterschiedlich dicke Komponenten mit der Kontaktseite in Richtung der ersten temporären Trägerschicht in den Freistellungen positioniert werden,
Fig. 14 eine Darstellung des Ergebnisses der erfindungsgemäßen Weiterverarbeitung des halbfertigen Produkts gemäß Fig. 13,
Fig. 15 eine Variante einer mit dem erfindungsgemäßen Verfahren hergestellten Leiterplatte bzw. eines Leiterplatten-Zwischenprodukts und die
Fig. 16-19 eine Variante der vorliegenden Erfindung unter Verwendung eines IMS-Bauteils als einzubettende Komponente.

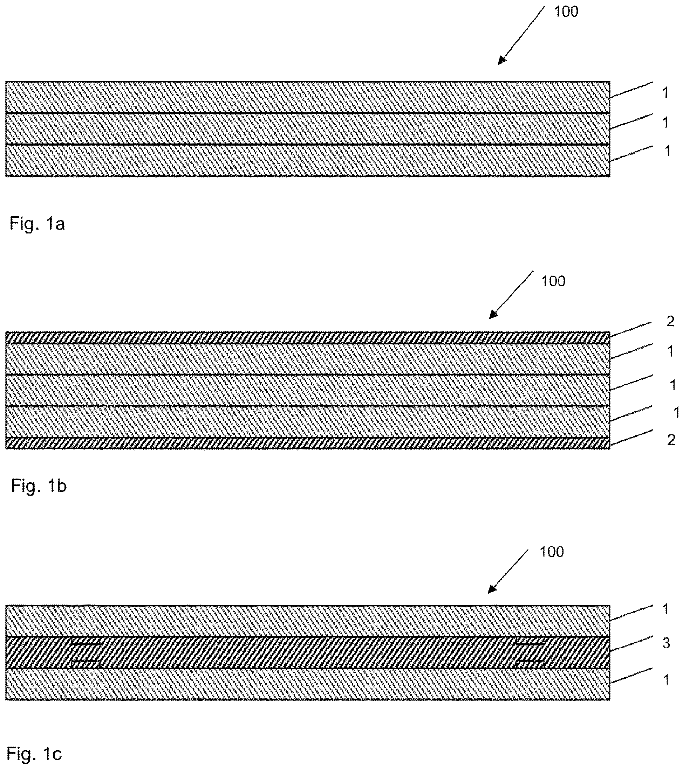

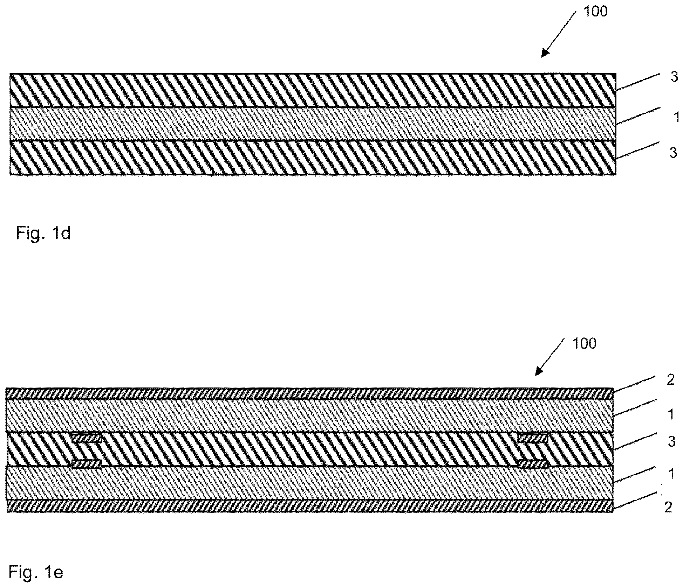

Die Fig. 1a) bis 1e) zeigen Varianten des Verbundes der Schichten der Leiterplatte bzw. des Leiterplatten-Zwischenprodukts, wie sie im Rahmen der vorliegenden Erfindung gemäß Schritt a) bereitgestellt werden können. Fig. 1a) zeigt hierbei einen Verbund 100, der nur aus Lagen aus einem Prepreg-Material 1 (Prepreg-Lagen) besteht, Fig. 1b) zeigt einen Verbund 100, der aus Prepreg-Lagen 1 und beidseitig außenliegenden Kupferschichten 2 besteht, Fig. 1c) zeigt einen Verbund 100, der aus außenliegenden Prepreg-Lagen 1 und einen zentral gelegenen Core 3 besteht, Fig. 1d) zeigt einen Verbund 100, der aus beidseitig außenliegenden Cores 3 und einer innenliegenden Prepreg-Lage 1 besteht, und Fig. 1e) zeigt einen Verbund 100, der aus einem innenliegendem Core 3 einer Mehrzahl von Lagen aus Prepreg-Material 1 und beidseitig außenliegenden Kupferschichten 2 besteht.

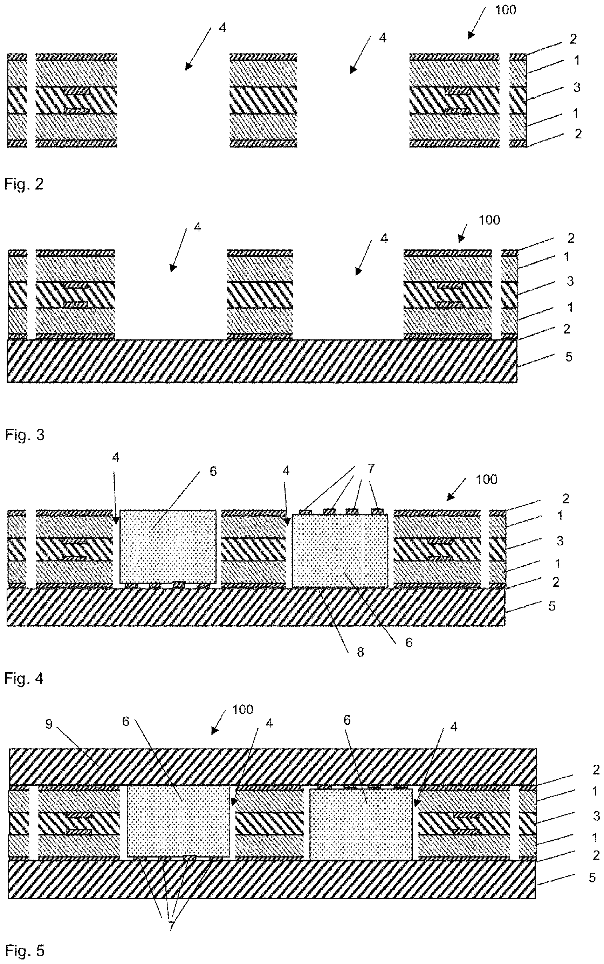

In Fig. 2 ist beispielhaft ein Verbund 100, wie in Fig. 1e), dargestellt gemäß Schritt b) mit Freistellungen 4 zur Aufnahme der einzubettenden Komponenten versehen worden. Nach dem Herstellen der Freistellungen 4 werden gemäß Schritt c) die Freistellungen 4 in dem Verbund 100 mit einer ersten temporären Trägerschicht 5, beispielsweise in Form eines Klebebands auf einer ersten Seite des Verbundes 100 abgedeckt (Fig. 3). Gemäß Schritt d) und wie in Fig. 4 dargestellt, werden in einem nächsten Verfahrensschritt die einzubettenden Komponenten 6 in die Freistellungen 4 bestückt bzw. in diesen positioniert. Wie in Fig. 4 erkennbar ist, können die Komponenten sowohl "face down" als auch "face up" positioniert werden, wobei sie im ersten Fall mit ihrer Kontaktseite bzw. ihren Kontaktpads 7 und im zweiten Fall mit ihrer Rückseite 8 an der ersten temporären Trägerschicht, die auf dieser ersten Seite des Verbundes in Form eines Klebebandes vorliegt, anhaften.

Zur Durchführung des erfindungsgemäßen Verfahrens ist es prinzipiell lediglich notwendig, zumindest den Bereich der Freistellung bzw. die Bereiche der Freistellungen mit einer ersten temporären Trägerschicht 5 abzudecken. In der industriellen Fertigung ist es jedoch zumeist einfacher, nicht nur den Bereich bzw. die Bereiche der Freistellungen mit einer ersten temporären Trägerschicht abzudecken, sondern die gesamte Fläche des Verbundes 100 mit einer kontinuierlichen ersten temporären Trägerschicht 5 zu bekleben.

In Fig. 5 ist nun zu erkennen, dass gemäß Schritt e) die Bereiche der Freistellungen auf der zweiten Seite des Verbundes 100 mit einer zweiten temporären Trägerschicht 9 abgedeckt werden, wobei es auch hier zumeist ökonomischer ist, nicht nur den Bereich der Freistellung bzw. die Bereiche der Freistellungen abzudecken, sondern eine kontinuierliche zweite temporäre Trägerschicht 9 über die gesamte Fläche des Verbundes 100 aufzubringen.

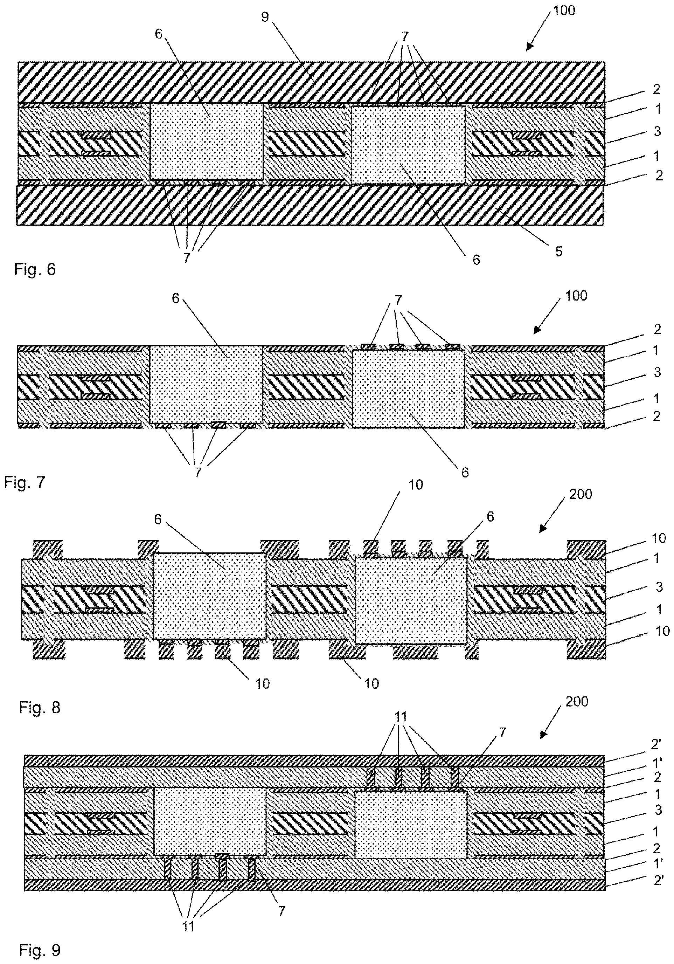

In Fig. 6 ist Schritt f) des erfindungsgemäßen Verfahrens, nämlich das Verpressen des Verbundes mit der Komponente bzw. den Komponenten unter Aushärtung des aushärtbaren Prepreg-Materials 1 dargestellt. Wie in Fig. 6 zu erkennen ist, werden die Hohlräume der Freistellungen 4 vom Harz der Lagen aus Prepreg-Material 1 ausgefüllt, sodass beim Aushärten eine zuverlässige Festlegung der Komponenten 6 im Verbund 100 erfolgt. Dadurch dass die ersten temporären Trägerschichten 5 und 9 den Verbund 100 zuverlässig räumlich begrenzen, liegen bei der in den bisherigen Figuren dargestellten Variante der Bestückung des Verbundes 100 mit Komponenten 6 die Kontaktpads 7 der Komponenten 6 nach den Entfernen der temporären Trägerschichten 5 und 9 (Fig. 7) frei und können, wie dies in Fig. 8 dargestellt ist, unmittelbar zur Ankontaktierung und dem Aufbau von hier nicht näher dargestellten Leiterzügen 10 in derselben Ebene a bzw. a' der Leiterplatte bzw. des Leiterplatten-Zwischenprodukts 200 unterzogen werden. Gemäß der in Fig. 9 gezeigten Variante kann jedoch auch ein weiterer Aufbau des Leiterplatten-Zwischenprodukts 200 erfolgen, in dem weitere Lagen aus Prepreg-Material 1' und Kontaktschichten bzw. Kupferschichten 2' nach bekannten Verfahren aufgebracht werden, wobei in diesem Fall die Ankontaktierung der Kontaktpads 7 der Komponenten 6 über sogenannten Mikrovias 11 erfolgt.

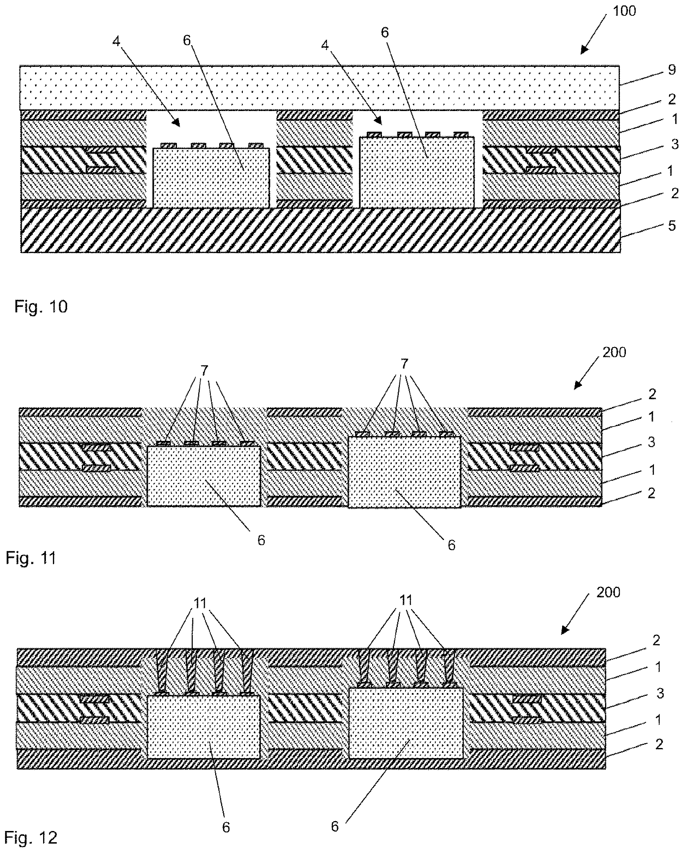

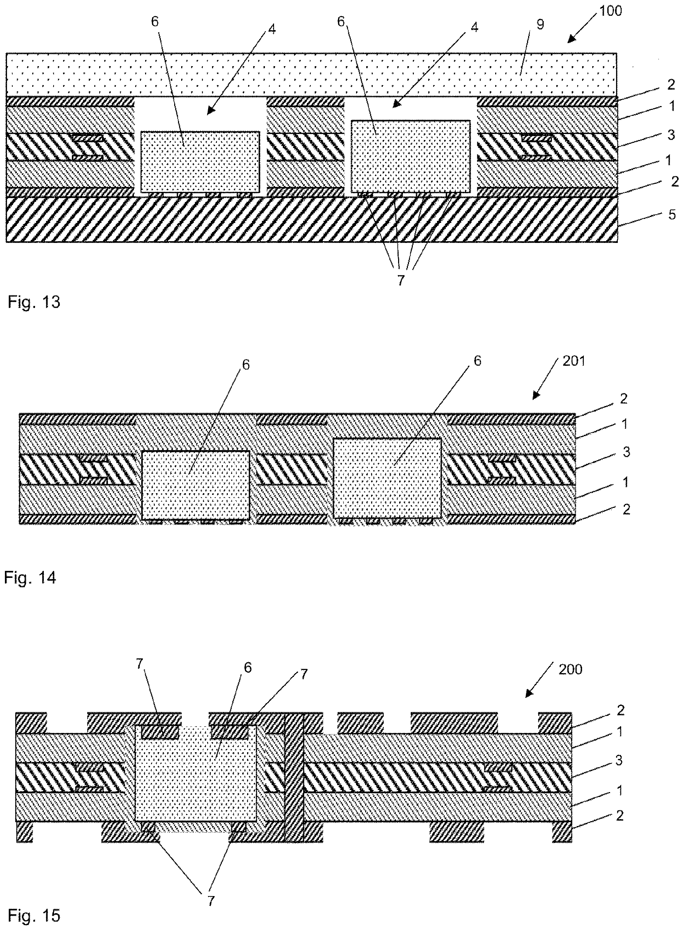

In Fig. 10 ist zu erkennen, dass Komponenten 6 unterschiedlicher Dicke in die Freistellungen 4 bestückt bzw. in diesen positioniert werden können, wobei in diesem Fall aufgrund des Umstandes, dass zwischen den Komponenten 6 und der zweiten temporären Trägerschicht ein Abstand besteht und die Komponenten 6 beim Verpressen nicht von der ersten temporären Trägerschicht 5 abgehoben werden dürfen, die zweite temporäre Trägerschicht 9 in diesem Fall kein Klebeband ist. Nach dem Verpressen gemäß Schritt f) des erfindungsgemäßen Verfahrens wird eine Leiterplatte bzw. ein Leiterplatten-Zwischenprodukt 200 erhalten, wie sie in Fig. 11 dargestellt ist, wobei eine Ankontaktierung der Komponenten 6 wiederum über Mikrovias 11 erfolgt (Fig. 12). Beim Bestücken unterschiedlich dicker Komponenten 6 in die Freistellungen 4 mit den Kontaktpads in Richtung der ersten temporären Trägerschicht 5, die in Form eines Klebebands vorliegt, muss die zweite temporäre Trägerschicht einen nicht haftende Oberfläche aufweisen, die zum Verbund 100 der Schichten der Leiterplatte bzw. des Leiterplatten-Zwischenprodukts ausgerichtet ist (fig. 13). Nach dem Verpressen gemäß Schritt f) des erfindungsgemäßen Verfahrens wird ein Leiterplatten-Zwischenprodukt 201 (Fig. 14) erhalten, welches wiederum gemäß Fig. 8 ankontaktiert werden kann.

Fig. 15 zeigt eine Variante der vorliegenden Erfindung, bei der eine Komponente 6 mit Kontakten 7 auf zwei gegenüberliegenden Seiten eingebettet wurde, wodurch ein vertikaler Stromfluss von einer Seite auf die andere Seite der Leiterplatte 200 ermöglicht wird.

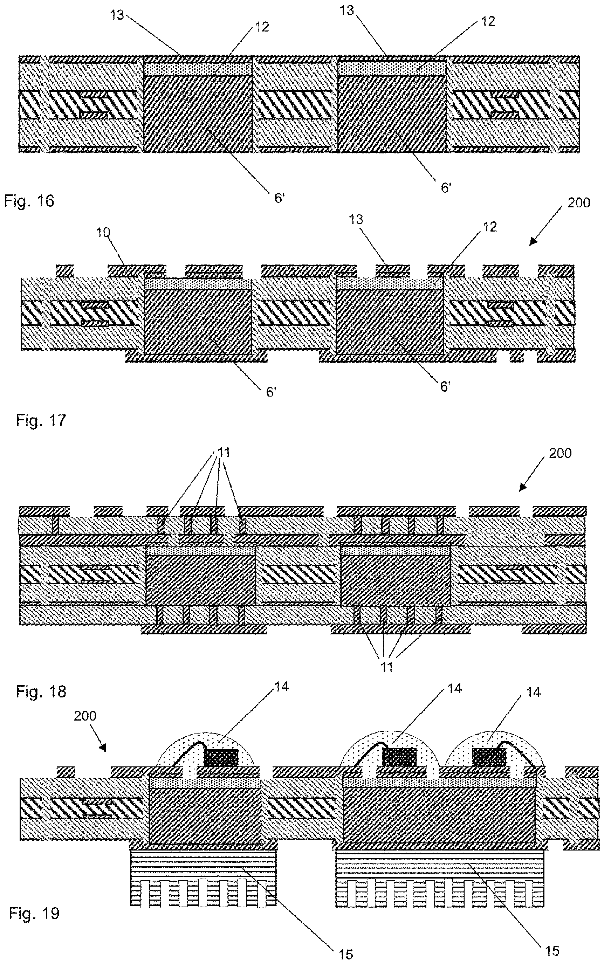

In Fig. 16 sind gemäß einer bevorzugten Ausführungsform der vorliegenden Erfindung die Komponenten 6 von IMS-Bauteilen 6' gebildet, wobei die Isolatorschicht des IMS-Bauteils 6' mit 12 und die leitende Schicht mit 13 bezeichnet ist. Das IMS-Bauteil 6' kann in herkömmlicher Weise ankontaktiert werden, wobei auch eine Ankontaktierung über Mikrovias 11 möglich ist (Fig. 18).

Besonders geeignet ist die Verwendung von IMS-Bauteilen zur Ableitung von Wärme, in dem in Figur 19 gezeigten Fall von Wärme, die von LED-Einheiten 14 in das Leiterplatten-Zwischenprodukt 200 eingebracht wird. In Figur 19 sind Kühlkörper 15 gezeigt, die die über die IMS-Bauteile 6' abgeleitete Wärme zusätzlich dissipieren.

Darüber hinaus wird ein Verfahren zum Einbetten einer Komponente in eine Leiterplatte bzw. ein Leiterplatten-Zwischenprodukt offenbart, wobei die Leiterplatte bzw. das Leiterplatten-Zwischenprodukt zumindest eine isolierende Schicht aus einem Prepreg-Material aufweisen kann und die Komponente durch das Harz des Prepreg-Materials festgelegt werden kann, mit den folgenden optionalen Schritten: a) Bereitstellen eines Verbundes 100 der Schichten der Leiterplatte bzw. des Leiterplatten-Zwischenprodukts 200, wobei dieser Verbund zumindest ein aushärtbares Prepreg-Material enthält, b) Herstellen einer Freistellung 4 in dem Verbund 100 zur Aufnahme der einzubettenden Komponente 6, c) Abdecken zumindest des Bereichs der Freistellung 4 mit einer ersten temporären Trägerschicht 5 auf einer ersten Seite des Verbundes, d) Positionieren der einzubettenden Komponente 6 in der Freistellung 4 mittels der ersten temporären Trägerschicht 5, e) Abdecken zumindest des Bereichs der Freistellung 4 auf der zweiten Seite des Verbundes 100 mit einer zweiten temporären Trägerschicht 9, f) Verpressen des Verbundes 100 mit der Komponente 6 unter Aushärtung des aushärtbaren Prepreg-Materials, g) Entfernen der temporären Träger schichten 5, 9.

Der Verbund 100 der Schichten der Leiterplatte bzw. des Leiterplatten-Zwischenprodukts 200 kann aus einer Mehrzahl von Lagen aus einem Prepreg-Material 1 bestehen.

Der Verbund 100 der Schichten der Leiterplatte bzw. des Leiterplatten-Zwischenprodukts 200 kann aus einer Mehrzahl von Lagen aus einem Prepreg-Material 1 und beidseitig außenliegenden Kupferschichten 2 bestehen.

Der Verbund 100 der Schichten der Leiterplatte bzw. des Leiterplatten-Zwischenprodukts 200 kann aus einer Mehrzahl von Lagen aus Prepreg-Material 1 und einem zentral gelegenen Core 3 bestehen.

Der Verbund 100 kann aus einer Mehrzahl von Lagen aus Prepreg-Material 1 und einem zentral gelegenen Core 3 sowie beidseitig außenliegenden Kupferschichten 2 bestehen.

Der Verbund 100 der Schichten der Leiterplatte bzw. des Leiterplatten-Zwischenprodukts 200 kann aus einer innenliegenden Schicht aus einem Prepreg-Material und beidseitig außenliegenden Cores 3 bestehen.

Der Verbund 100 der Schichten der Leiterplatte bzw. des Leiterplatten-Zwischenprodukts 200 kann im Wesentlichen die Dicke der einzubettenden Komponente 6 aufweisen.

Die Leiterplatte bzw. das Leiterplattenzwischenprodukt 200 kann eine Mehrzahl von Komponenten 6 einbetten.

Komponenten 6 unterschiedlicher Dicke können in die jeweiligen Freistellungen 4 bestückt werden und die zweite temporäre Trägerschicht 9 kann mit einer nichthaftenden Oberfläche zum Verbund 100 der Schichten der Leiterplatte bzw. des Leiterplatten-Zwischenprodukts 200 ausgerichtet werden.

Die erste Seite des Verbundes 100 kann eine Kontaktseite der Leiterplatte bzw. des Leiterplatten-Zwischenprodukts 200 sein und die einzubettende Komponente 6 kann face-up zu dieser Kontaktseite in der Freistellung 4 befestigt werden.

Sowohl die erste Seite als auch die zweite Seite des Verbundes 100 können eine Kontaktseite der Leiterplatte bzw. des Leiterplatten-Zwischenprodukts 200 sein.

Eine Komponente 6 kann mit Kontakten 7 auf zwei gegenüberliegenden Seiten der Komponente 6 eingebettet werden.

Die Komponente 6 können aus der Gruppe bestehend aus einem integrierten Schaltkreis, einer LED, einem Kühlkörper und einer Leiterplatte, insbesondere einer mehrlagigen Leiterplatte ausgewählt werden.

Die Komponente 6 kann ein IMS-Bauteil 6' sein.

Die erste temporäre Trägerschicht 5 kann in Form eines Klebebandes ausgebildet sein.

Die Leiterplatte bzw. das Leiterplatten-Zwischenprodukt können so hergestellt werden.

## Patentansprüche

1. Leiterplatte (200) bzw. Leiterplatten-Zwischenprodukt (200), wobei die Leiterplatte (200) bzw. das Leiterplatten-Zwischenprodukt (200) einen Verbund (100) von Schichten mit zumindest einer isolierenden Schicht (1) aus einem Prepreg-Material, wobei der Verbund (100) von Schichten eine erste Seite und eine zweite Seite hat, und eine in dem Verbund (100) von Schichten eingebettete Komponente (6) aufweist, die Kontakte (7) hat und durch ein Harz des Prepreg-Materials festgelegt ist,
wobei die Kontakte (7) der Komponente (6) in derselben Ebene der Leiterplatte (200) bzw. des Leiterplatten-Zwischenprodukts (200), die durch die erste Seite definiert ist, unmittelbar durch erste Leiterzüge (10) oder Mikrovias (11) ankontaktiert sind.

2. Leiterplatte (200) bzw. Leiterplatten-Zwischenprodukt (200) gemäß dem vorherigen Anspruch, wobei
der Verbund (100) von Schichten beidseitig außenliegende Kupferschichten (2) hat, die die erste Seite und die zweite Seite definieren.

3. Leiterplatte (200) bzw. Leiterplatten-Zwischenprodukt (200) gemäß einem der vorherigen Ansprüche, wobei
die Komponente (6) eine Rückseite (8) an einer Seite aufweist, die jener Seite gegenüberliegt, an der die Kontakte (7) angeordnet sind, und wobei die Rückseite (8) in derselben Ebene der Leiterplatte (200) bzw. des Leiterplatten-Zwischenprodukts (200) liegt, die durch die zweite Seite definiert ist.

4. Leiterplatte (200) gemäß dem vorherigen Anspruch, wobei
die Rückseite (8) durch zweite Leiterzüge (10) unmittelbar ankontaktiert ist.

5. Leiterplatte (200) bzw. Leiterplatten-Zwischenprodukt (200) gemäß einem der vorherigen Ansprüche, wobei
zwischen den ersten Leiterzügen (10) oder Mikrovias (11) einerseits und den Kontakten (7) andererseits keine isolierende Schicht angeordnet ist.

6. Leiterplatte (200) bzw. Leiterplatten-Zwischenprodukt (200) gemäß einem der vorherigen Ansprüche, wobei
der Verbund (100) der Schichten der Leiterplatte bzw. des Leiterplatten-Zwischenprodukts (200) aus einer Mehrzahl von Lagen aus einem Prepreg-Material (1) besteht.

7. Leiterplatte (200) bzw. Leiterplatten-Zwischenprodukt (200) gemäß einem der vorherigen Ansprüche, wobei
der Verbund (100) der Schichten der Leiterplatte bzw. des Leiterplatten-Zwischenprodukts (200) aus einer Mehrzahl von Lagen aus Prepreg-Material (1) und einem zentral gelegenen Core (3) besteht.

8. Leiterplatte (200) bzw. Leiterplatten-Zwischenprodukt (200) gemäß einem der vorherigen Ansprüche, wobei
der Verbund (100) der Schichten der Leiterplatte bzw. des Leiterplatten-Zwischenprodukts (200) aus einer innenliegenden Schicht (1) aus einem Prepreg-Material und beidseitig außenliegenden Cores (3) besteht.

9. Leiterplatte (200) bzw. Leiterplatten-Zwischenprodukt (200) gemäß einem der vorherigen Ansprüche, wobei
in dem Verbund (100) von Schichten eine Mehrzahl von Komponenten (6) eingebettet ist.

10. Leiterplatte (200) bzw. Leiterplatten-Zwischenprodukt (200) gemäß dem vorherigen Anspruch, wobei
die Komponenten (6) mit unterschiedlicher Dicke in dem Verbund (100) von Schichten eingebettet sind.

11. Leiterplatte (200) bzw. Leiterplatten-Zwischenprodukt (200) gemäß einem der vorherigen Ansprüche, wobei
die erste Seite des Verbundes (100) eine Kontaktseite der Leiterplatte bzw. des Leiterplatten-Zwischenprodukts (200) ist und die eingebettete Komponente (6) face-up zu dieser Kontaktseite befestigt ist.

12. Leiterplatte (200) bzw. Leiterplatten-Zwischenprodukt (200) gemäß einem der vorherigen Ansprüche, wobei
sowohl die erste Seite als auch die zweite Seite des Verbundes (100) eine Kontaktseite der Leiterplatte bzw. des Leiterplatten-Zwischenprodukts (200) ist.

13. Leiterplatte (200) bzw. Leiterplatten-Zwischenprodukt (200) gemäß einem der vorherigen Ansprüche, wobei
die Komponente (6) mit den Kontakten (7) auf zwei gegenüberliegenden Seiten der Komponente (6) eingebettet ist.

14. Leiterplatte (200) bzw. Leiterplatten-Zwischenprodukt (200) gemäß einem der vorherigen Ansprüche, wobei
die Komponente (6) aus der Gruppe bestehend aus einem integrierten Schaltkreis, einer LED, einem Kühlkörper und einer Leiterplatte, insbesondere einer mehrlagigen Leiterplatte ausgewählt ist.

15. Leiterplatte (200) bzw. Leiterplatten-Zwischenprodukt (200) gemäß einem der vorherigen Ansprüche, wobei
die Komponente (6) ein IMS-Bauteil (6') ist.
